(19) Europäisches Patentamt
European Patent Office
Office européen des brevets

(11) **EP 2 860 285 B1**

(12) **EUROPEAN PATENT SPECIFICATION**

(45) Date of publication and mention of the grant of the patent:
**14.09.2016   Bulletin 2016/37**

(21) Application number: **13188508.9**

(22) Date of filing: **14.10.2013**

(51) Int Cl.:
*C23C 14/16* (2006.01)          *C23C 14/32* (2006.01)
*C23C 14/35* (2006.01)          *C23C 28/02* (2006.01)
*F01D 5/28* (2006.01)          *C23C 14/06* (2006.01)

(54) **Method for increasing heat resistance of metallic articles**

Verfahren zur Erhöhung der Wärmebeständigkeit von metallischen Gegenständen

Procédé pour augmenter la résistance thermique d'articles métalliques

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.04.2015   Bulletin 2015/16**

(73) Proprietor: **Rigas Tehniska universitate**
**Riga 1658 (LV)**

(72) Inventors:
• **Urbahs, Aleksandrs**
  **1029 Rîga (LV)**
• **Savkovs, Konstantîns**
  **1001 Rîga (LV)**
• **Urbaha, Margarita**
  **1029 Rîga (LV)**
• **Rudzîtis, Jânis**
  **2111 Kekavas novads (LV)**

(74) Representative: **Fortuna, Jevgenijs**
**Foral Patent Law Office**
**P.O. Box 98**
**1050 Riga (LV)**

(56) References cited:
**EP-A1- 0 668 369       US-A1- 2010 255 340**

## Description

<u>Technical Field</u>

The invention relates to metallurgical industry, in particular to processesses for creating protective coatings for machine parts, and can be used in engineering industry, mainly, aviation and shipbuilding, for example, in gas turbine engine blades renovation and manufacturing.

<u>Background Art</u>

There are known various methods for creating protective coatings for machines' parts.

For example, there is known a process for making protective coating on surface of machines parts by electroplating technique, such as chromium plating (Golego N.L. et. al. Remont letatelnyh apparatov. - Moskva, Transport, 1977.- 424 p). This process is characterized in possibility to adjust the properties of a single-layer coating with electrolysis mode switching. However, this process did not find wide application due to increased fragility of this type of coating, which leads in practice to the secession of its edges. In addition, the given process does not ensure protection of parts, operating at high temperatures, but the technological process used in creation of coating does not meet the requirements of ecological safety.

There is also known method of creating a single layer multi-component protective coating for helicopter gas turbine engine blades (Skazhutyn Yu.A. et. al. Sposob khimikotermicheskoy obrabotki splavov na nikelevoy osnove - Author's certificate No. 1527320, 1989). The method is implemented as follows: a suspension with the following content of components by weight is prepared: aluminum powder - 10-15%, zirconium powder - 1-10%. As binder 20-40% lacquer solution is used. After mixing of components for 20-30 minutes the suspension is subjected to ultrasonic treatment. Further the suspension is applied to previously prepared blade's surface by use of paint-pulverizer, then the article is being dried for an hour and further - high-temperature annealing for 1-2 hours is performed.

This method allows forming a single layer two component coatings, which are characterized by low adhesion strength and low operational durability. In addition, said nethod has low precision and technological complexity, and it can be used only on parts made of nickel.

There is known a method of deposition of coating by ion-plasma technique, according to which multilayer coating is obtained, containing at least two components, wherein content of the coating may vary in thickness (US 4814056). This method is technologically complicate. Between the deposition source and the surfaces of the article a protective mask having a cutting is disposed. For the displacement of the mask a specific device is used. This greatly reduces the accuracy of application of the coating with the necessary combining its components and maintainance of separation. The chemical content of the resulting protective coating has discrete nature with the pronounced ratio of coating properties due to the interrupted displacement of the protective mask. Such a ratio causes occurence of internal stress leading to deterioration of the operation properties of the parts.

There are known multi-component coatings and a method for applying thereto (A. Urbahs et.al. Wear Resistant Nanostructured Multi-component Coatings. NATO Science for Peace and Security Series - B: Physics and Biophysics; 2012). The method provides for formation of Ti-Al-N double-layer wear resistant coating on metal articles by ion-plasma deposition. The method allows to avoid or control the droplet phase while maintaining efficiency of ion bombardment. However, the known method is not suitable to increase heat resistance of the product.

<u>Disclosure of the Invention</u>

The aim of the invention is the increase of heat resistance and durability of articles made of titanium, Ti-Al intermetallic alloys, heat-resistant steels and heat-resistant nickel-based alloys.

The proposed method for forming of coating is based on ion-plasma spraying to a surface of metallic article forming triple-layer coating, where the method includes the following sequential steps: (i) insertion of metallic article in a vacuum chamber of an equipment designed for depositing of strengthening coating under vaccum conditions; (ii) evacuation of the vacuum chamber of the equipment; (iii) optionally - cleaning and heating of the article in the vacuum chamber of the equipment up to required temperature (this step is being performed depending on the type of the equipment used; typically heating of the article is performed from 0.2 to 0.4 of the melting temperature of the respective metall); (iv) depositing on the article predominantly of intermetallic TiAl or $Ti_3Al$ layer with atomic aluminum content of 40-75% by titanium and aluminum evaporation or sputtering in an inert gas atmosphere; (v) depositing on the article of conglomerate coating containing intermetallides TiAl, $Ti_3Al$ alloyed by nitrogen, and nitrides (TiAl)N with atomic aluminum nitride content 30-70%, by titanium and aluminum evaporation or sputtering in an inert gas and nitrogen atmosphere; (vi) depositing on the article of nitride (TiAl)N layer with atomic aluminum content in the metallic component 40-70%, by titanium and aluminum evaporation or sputtering in an inert gas and nitrogen atmosphere, wherein deposition of the three layers is performed preventing or controlling the droplet phase by use of a magnetron or other metal evaporation or sputtering sources, which do not form droplet phase, or by use of a shield installed between an electric arc evaporator and the article, on which the coating is being applied; wherein titanium and aluminum evaporation or sputtering time is chosen such, that thickness of the intermetallic layer is not more than 2 $\mu$m, thickness of the conglomerate coating is not more than 10 $\mu$m and thickness of the nitride layer is not more than 1 $\mu$m. Gas supply - inert gases and nitrogen - is performed separately or in the form of ready for use mixture of gasses (depending on constructive characteristics of the vacuum device and type of deposited materials sources). Deposition of intermetallic, conglomerate and nitride layer on the article is performed by titanium and aluminum or titanium and aluminum alloy evaporation or sputtering. Before heating of the article the surface activation and purifying of the article can be performed by glow discharge in an argon atmosphere untill the micro-arc extinction from surface of the article.

According to preferable embodiment of the invention titanium and aluminum evaporation or sputtering is caried out by magnetron and electric arc evaporator, being provided with a shield, which is mounted between the electric arc evaporator and the article, on which coating is being applied, where the article is being moved in the vacuum chamber of the equipment during the application of coatings.

The internal intermetallic titanium aluminum (TiAl or Ti3Al) based layer serves as a diffuse coupling between the basic coating and the main material and forms a transition fine-grained structure. The conglomerate intermediate basic resistant layer is formed to equalize stress between the outer and inner layer. The given layer is titanium and aluminum nitride mechanical mixture in a solid solution matrix from nitrogen in titanium or aluminum; it is formed as a barrier layer that is resistant to coating absorption. The outer nitride layer is formed on the base of the mixture of aluminum and titanium nitride. It has good mechanical, corrosion and heat resistance characteristics, which provide high operational properties of the article.

The triple-layer coating is obtained according to the method described above. The thickness of the first - intermetallic TiAl or Ti$_3$Al layer is not more that 2 $\mu$m, atomic aluminum content is from 40 to 75%; the thickness of the second - conglomerate layer containing intermetallides TiAl, Ti$_3$Al alloyed by nitrogen and nitrides (TiAl)N is not more than 10 $\mu$m, atomic aluminum nitride content is from 30 to 70%; the thickness of the third - nitride (TiAl)N layer is not more than 1 $\mu$m, the atomic aluminum content in the metallic component is from 40 to 70%.

Brief Discription of Drawings

Fig. 1 is a scheme of disposition of deposition materials sources in the vacuum equipment according to one embodiment of the invention;
Fig. 2 - a cross-section of the gas turbine engine blade, to which the proposed coating is applied.

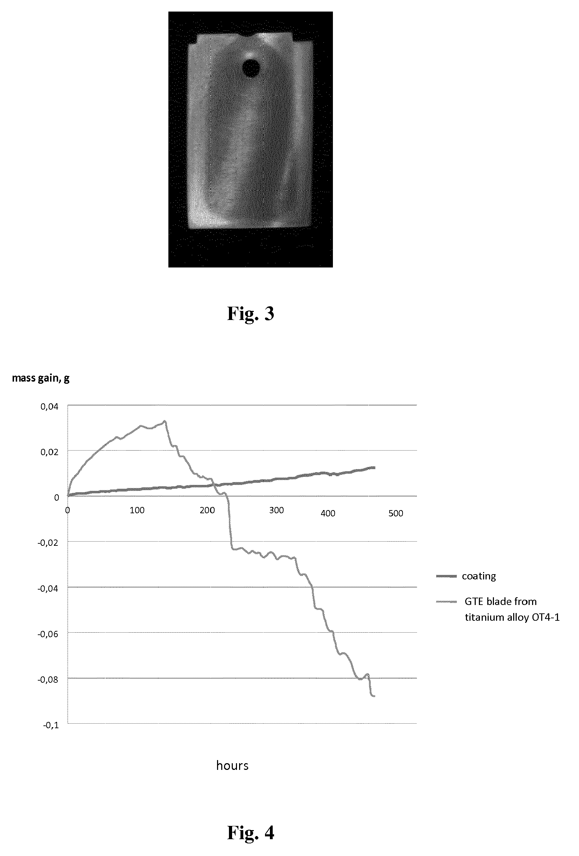

Fig. 3 - picture of a gas turbine engine (GTE) blade TV2-117A from titanium alloy OT4-1 with the proposed coating (top view);
Fig. 4 - diagram showing mass gain when conducting thermal resistance testing of GTE TV2-117A blade from titanium alloy OT4-1 with and without proposed coating at 730° C temperature.

Example of the Implementation of the Invention

Application of the proposed triple-layer multi-component coating was carried out on a gas turbine engine (GTE) compressor blades made of deformable titanium alloy OT4-1. The article from said alloy is exploited at an operating temperature of up to 350°C; the chemical content of the alloy OT4-1 is shown in the Table 1.

Table 1.

| The chemical content of the alloy OT4-1, % | | | | | | | | | | |
|---|---|---|---|---|---|---|---|---|---|---|
| Fe | C | Si | Mn | N | Ti | Al | Zr | O | H | Other admixtures |
| $\geq$ 0.3 | $\geq$0.1 | $\geq$0.15 | 0.7-2 | $\geq$0.05 | 94.138-98.3 | 1-2.5 | $\geq$0.3 | $\geq$0.15 | $\geq$0.012 | 0.3 |

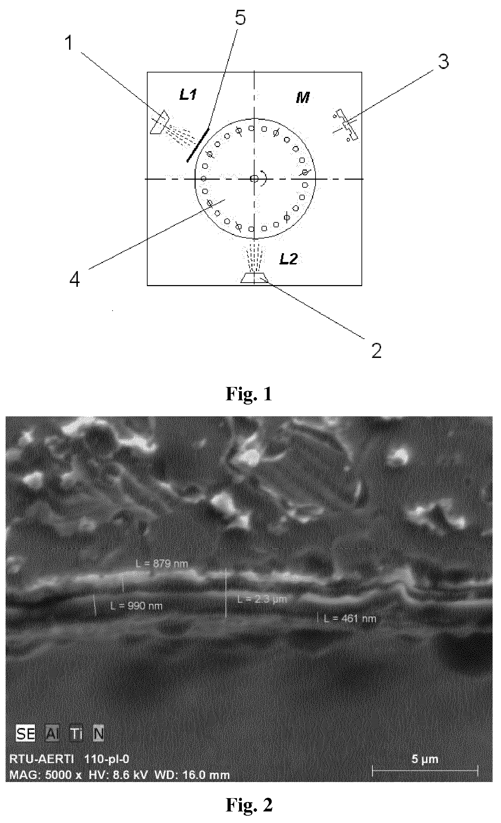

Coating was applied by vacuum equipment (Fig. 1) by using three deposited material sources - two titanium electric arc evaporators 1 and 2 with electromagnetic cathode spot stabilization on the cathode end face and electromagnetic focusing of the material, which is to be sprayed, in the direction of the main material by separation of the droplet phase, and aluminum planar direct current magnetron 3. The GTE blade was fixed on a rotary table 4 on cylindrical supports, rotating around their axis, thus ensuring ability to move the blade in a vacuum chamber of the equipment.

The electric arc evaporator 1 is a source of deposited material - titanium, and the device for the blade surface primary ion bombardment at preliminary cleaning. The arc source has a minimum of evaporator's current - 45A. Since there is a large amount of droplets forming during titanium evaporation and the productivity of an arc source in nitrogen atmosphere is greater than of aluminum magnetron, a shield 5 was installed before the arc evaporator 1. This allows to ensure the given relationship between the titanium and aluminum, and reduce the concentration of droplet phase in a coating. The electric arc titanium evaporator 2 was used only for heating and blade cleaning before deposition. For the deposition of the aluminum component of the coating - aluminium planar direct current magnetron with disc-type receiving cathode having diameter of 190 mm and thickness of 8 mm was used. The adjustment range of spraying current was 0-10A. Voltage on the cathode - up to 1000V.

Gases (argon and nitrogen) supply was carried out separately. Argon was intended to ensure aluminium spraying and adjustment of base pressure of the chamber at article surface ion cleaning with glow discharge and ion bombardment, as well as at sputtering. Argon was fed through the inlet valve with manual adjustment of the gas flow. Nitrogen, in turn, was fed through an electromagnetic inlet valve with automatic control system and control by use of ionization-thermocouple vacuum meter.

Technical characteristics of the deposition conditions:

(i) the inner layer deposition: current of titanium evaporator - 50A, current of aluminium magnetron -7A, argon pressure - 0.08 Pa, common pressure in the chamber - 0.08 Pa, base voltage on articles - 60V, time of deposition- 10 min;

(ii) the interlayer deposition: current of titanium evaporator - 50A, current of aluminium magnetron -7A, argon pressure - 0.4 Pa, nitrogen pressure - 0.027 Pa, common pressure in the chamber - 0.043 Pa, base voltage on the articles - 60V, time of deposition - 60 min;

(iii) the outer layer deposition: current of titanium evaporator - 50A, current of aluminium magnetron -7.2 A, argon pressure - 0.4 Pa, nitrogen pressure - 0,2 Pa, common pressure in the chamber - 0.06 Pa, base voltage on the articles - 80V, time of deposition - 40 min.

A total thickness of the coating obtained is about 2.3 $\mu$m (Fig. 2), including the thickness of the inner intermetallic coating - 879 nm, the thickness of the conglomerate interlayer - 990 nm, the thickness of the outer nitride layer - 461 nm.

According to the invention the decrease of weight gain of the complex coating weight, depending on the deposition time of each layer, is calculated using the formula:

$$\Delta mi = \Delta m_{wp} - aI - bK - cN \qquad (1),$$

where $\Delta mi$ - weight gain of the coated blades; $\Delta m_{wp}$ - weight gain of uncoated blades; a - coefficient of influence of intermetallic coating; b - coefficient of influence of conglomerate coating; c - coefficient of influence of nitride coating; I - time of sputtering of intermetallic coating, min; K - time of sputtering of conglomerate coating, min; N - time of sputtering of nitride coating, min;

$$\Delta mi = \Delta m_{wp} - 0.00051I - 0.000327K - 0.000007N$$

The effectiveness of each layer in respect of the thickness of layers on compressor stator blades of titanium alloy OT4-1 of the engine TV2-117A:

$$a/Vint = 0.0214 \text{ g}/\mu m \quad b/Vkong = 0.0291 \text{ g}/\mu m \quad c/Vnit = 0.00091 \text{ g}/\mu m$$

The use of the invention allows significantly increase the heat resistance of various engineering products and their resistance to high-temperature gas corrosion.

**Claims**

1.    A method for increasing heat resistance of articles made of titanium, Ti-Al intermetallic alloy, heat-resistant steel or heat resistant nickel-based alloy, by ion-plasma deposition, forming on said article triple-layer coating, where the method includes the following consequtive steps:

(i) insertion of said article in a vacuum chamber of an equipment, designed for depositing of strengthening coatings under vaccum conditions,

(ii) evacuation of the vacuum chamber of the equipment,

(iii) optionally - cleaning of the article and heating in the vacuum chamber of the equipment,

(iv) depositing of intermetallic TiAl or $Ti_3Al$ layer with atomic aluminum content 40-75% on the article by titanium and aluminum evaporation or sputtering in an inert gas atmosphere,

(v) depositing of a conglomerate coating containing a nitrogen-doped intermetallic TiAl, $Ti_3Al$ and nitrides (TiAl)N with atomic aluminum nitride content 30-70% on the article by titanium and aluminum evaporation or sputtering in an inert gas and nitrogen atmosphere,

(vi) depositing of nitride (TiAl)N layer with atomic aluminum content in metallic component from 40 to 70% on the article by titanium and aluminum evaporation or sputtering in an inert gas and nitrogen atmosphere, wherein depositing of the three layers is performed preventing or controlling the droplet phase by use of a magnetron or other metal evaporation or sputtering sources, which do not form droplet phase, or by use of a screen installed between an electric arc evaporator and the article, on which the coating is being applied, where titanium and aluminum evaporation or sputtering time is chosen such, that the thickness of the intermetallic layer is not more than 2 $\mu$m, the thickness of the conglomerate layer is not more than 10 $\mu$m and the thickness of the nitride layer is not more than 1 $\mu$m.

2. The method according to claim 1, **characterized in that** before heating of the article the surface activation and cleaning by glow discharge in argon atmosphere is performed until micro arc dissapears from the surface of the article.

3. The method according to any of the preceeding claims, **characterized in that** aluminum evaporation or sputtering on the surface of the article is carried out by use of magnetron (3), and titanium evaporation or sputtering on the surface of the article is carried out by use of electric arc evaporator (1) or (2), equipped with a screen (5) mounted between the electric arc evaporator and the article, on which the coating is being applied, where the article, on which heat-resistant coating is deposited, is installed on a rotating table (4), which during the depositing of the intermetallic, conglomerate and/or nitride layers on the article rotates about its axis thus ensuring movement of the article in a vacuum chamber of the equipment.

4. The method according to any of the preceeding claims, **characterized in that** gas supply - inert gases and nitrogen - is performed controllably separately or in the form of ready for use mixture of gasses.

5. The method according to any of the preceeding claims, **characterized in that** deposition of the intermetallic, conglomerate and nitride layers on the article is performed by titanium and aluminum alloy evaporation or sputtering.

6. A triple-layer coating, obtained according to the method, set forth in the preceeding claims, where the thickness of the first - intermetallic TiAl or $Ti_3Al$ layer is not more than 2 $\mu$m, atomic aluminum content is in the range between 40 and 75%; the thickness of the second - conglomerate layer, containing nitrogen-doped intermetallic TiAl, $Ti_3Al$ and nitrides (TiAl)N, is not more than 10 $\mu$m, atomic aluminum nitride content is in the range between 30 and 70%; the thickness of the third - nitride (TiAl)N layer is not more than 1 $\mu$m, atomic aluminum content in metallic component is in the range between 40 and 70%.

**Patentansprüche**

1. Eine Methode zur Erhöhung des Hitzewiderstands eines Gegenstands aus Titan, einer Ti-A1 intermetallischen Legierung, eines hitzebeständigen Stahls oder einer hitzebeständigen Legierung auf Nickelbasis durch Ionenplasmaabscheidung, wobei sich auf dem besagten Gegenstand eine dreilagige Beschichtung bildet, und das Verfahren die nachfolgend genannten Schritte umfasst:

(i) Einführen des besagten Gegenstands in eine Vakuumkammer eines Geräts, die für die Beschichtung mit Verstärkungsschichten unter Vakuumbedingungen ausgelegt ist,

(ii) Entleerung der Geräte-Vakuumkammer,

(iii) optionale Reinigung des Gegenstandes und Erhitzung in der Vakuumkammer des Geräts,

(iv) Beschichtung mit der intermetallischen TiAL oder $T_3Al$ Schicht mit einem Atom-Aluminiumgehalt von 40-75 % auf dem Titangegenstand durch Titan- und Aluminiumverdampfung oder -zerstäubung in einer Edelgasatmosphäre,

(v) Auftragen einer Konglomeratschicht, die stickstoffdotierte intermetallische TiAl, $Ti_3Al$ und Nitride (TiAl)N mit einem Atom-Aluminiumnitridgehalt von 30-70 % enthält auf den Gegenstand durch Titan- und Aluminiumverdampfung oder -zerstäubung in einer Edelgas- oder Sauerstoffatmosphäre.,

(vi) Abscheiden einer Nitrid (TiAl) N-Schicht mit einem Atom-Aluminiumgehalt in einer metallischen Komponente aus 40 bis 70 % auf den Gegenstand durch Titan- und Aluminiumverdampfung oder -zerstäubung in einer Edelgas- und Stickstoffatmosphäre, wobei die Abscheidung der drei Schichten durch Verhinderung oder Kontrolle der Tröpfchenphase mithilfe eines Magnetrons oder einer anderen Metallverdampfungs- oder Zerstäubungsquelle geschieht, die keine Tröpfchenphase bildet oder durch Verwendung eines Siebes, das zwischen einem elektrischen Lichtbogenverdampfer und dem Gegenstand angebracht ist und auf das die Beschichtung aufgebracht wird, wobei die Zeit der Titan- und Aluminiumverdampfung oder -zerstäubung so gewählt wird, dass die Dicke der intermetallischen Schicht nicht mehr als 2 $\mu$m, die Dicke der Konglomeratschicht nicht mehr als 10 $\mu$m und die Dicke der Nitridschicht nicht mehr als 1 $\mu$m beträgt.

2. Das Verfahren nach Anspruch 1 ist **dadurch gekennzeichnet,dass** vor dem Erhitzen des Gegenstands die Oberflächenaktivierung und Reinigung durch Glimmentladung in einer Argon-Atmosphäre durchgeführt wird, bis der Mikrobogen von der Oberfläche des Gegenstands verschwindet.

3. Das Verfahren nach einem der vorhergehenden Ansprüche ist **dadurch gekennzeichnet, dass** die Aluminiumverdampfung oder -zerstäubung auf der Oberfläche des Gegenstands mithilfe eines Magnetrons (3) und die Titanverdampfung oder -zerstäubung auf der Oberfläche des Gegenstandes mithilfe eines elektrischen Lichtbogenverdampfers (1) durchgeführt oder (2) mit einem Bildschirm ausgestattet (5) wird, der sich zwischen dem elektrischen Lichtbogenverdampfer und dem Gegenstand, auf den die Beschichtung aufgebracht wird, befindet, wobei der Gegenstand, auf den die hitzebeständige Beschichtung aufgetragen wird, auf einem Drehtisch (4) installiert ist, der sich während des Abscheidens der intermetallischen, Konglomerat- und/oder Nitridschichten auf den Gegenstand um seine eigene Achse dreht und sicherstellt, dass sich der Gegenstand in einer Vakuumkammer des Geräts bewegt.

4. Das Verfahren nach einem der vorhergehenden Ansprüche ist **dadurch gekennzeichnet, dass** die Gaszufuhr - Edelgase und Stickstoff - getrennt steuerbar ist oder in Form einer gebrauchsfertigen Gasmischung erfolgt.

5. Das Verfahren nach einem der vorhergehenden Ansprüche ist **dadurch gekennzeichnet, dass** die Abscheidung der intermetallischen, Konglomerat- und Nitridschichten auf den Gegenstand durch Verdampfung oder Zerstäubung einer Titan- und Aluminiumlegierung geschieht.

6. Dreilagige Beschichtung, die nach dem in den vorausgehenden Ansprüchen genannten Verfahren durchgeführt wird, wobei die Dicke der ersten - intermetallischen TiAl oder Ti$_3$Al Schicht nicht mehr als 2 $\mu$m beträgt, der Atom-Aluminiumgehalt im Bereich zwischen 40 und 75 % liegt; die Dicke der zweiten Konglomeratschicht, die stickstoffdotiertes intermetallisches TiAl, Ti$_3$Al und Nitride (TiAl) N enthält, nicht mehr als 10 $\mu$m beträgt, der Atom-Aluminiumnitridgehalt im Bereich zwischen 30 und 70 % liegt, die Dicke der dritten Nitrid (TiAl) N-Schicht nicht mehr als 1 $\mu$m beträgt und der Atom-Aluminiumgehalt in der metallischen Komponente im Bereich zwischen 40 und 70 % liegt.

## Revendications

1. Procédé pour augmenter la résistance à la chaleur d'un article en titane, alliage intermétallique Ti-Al, acier thermorésistant ou alliage thermorésistant à base de nickel, par dépôt par plasma ionique, formant sur ledit article un revêtement à triple couche, où le procédé comprend les étapes consécutives suivantes :

(i) insertion dudit article dans une chambre à vide d'un équipement, conçu pour le dépôt de revêtements de renforcement dans des conditions sous vide,
(ii) mise sous vide de la chambre à vide de l'équipement,
(iii) éventuellement - nettoyage de l'article et chauffage dans la chambre à vide de l'équipement,
(iv) dépôt de la couche intermétallique de TiAl ou de Ti$_3$Al avec une teneur atomique en aluminium de 40 à 75 % sur l'article par évaporation ou pulvérisation de titane et d'aluminium dans une atmosphère de gaz inerte,
(v) dépôt d'un revêtement congloméré contenant TiAl, Ti$_3$Al et des nitrures (TiAl)N, intermétalliques dopés à l'azote avec une teneur atomique en nitrure d'aluminium de 30 à 70 % sur l'article par évaporation ou pulvérisation de titane et d'aluminium dans une atmosphère de gaz inerte et d'azote,
(vi) dépôt d'une couche de nitrure (TiAl)N avec une teneur atomique en aluminium dans le composant métallique allant de 40 à 70 % sur l'article par évaporation ou pulvérisation de titane et d'aluminium dans une atmosphère de gaz inerte et d'azote, dans lequel le dépôt des trois couches est effectué en empêchant ou en régulant la phase gouttelette par l'utilisation d'un magnétron ou d'autres sources d'évaporation ou pulvérisation de métal, qui ne forment pas de phase gouttelette, ou par l'utilisation d'un écran installé entre un évaporateur à arc électrique et l'article, sur lequel le revêtement est appliqué, où le temps d'évaporation ou de pulvérisation du titane et de l'aluminium est choisi de telle sorte que l'épaisseur de la couche intermétallique n'est pas supérieure à 2 $\mu$m, l'épaisseur de la couche conglomérée n'est pas supérieure à 10 $\mu$m et l'épaisseur de la couche de nitrure n'est pas supérieure à 1 $\mu$m.

2. Procédé selon la revendication 1, **caractérisé en ce que**, avant chauffage de l'article, l'activation et le nettoyage de surface par décharge luminescente dans une atmosphère d'argon sont effectués jusqu'à ce qu'un micro-arc disparaisse de la surface de l'article.

3. Procédé selon l'une quelconque des revendications précédentes, **caractérisé en ce que** l'évaporation ou pulvérisation d'aluminium sur la surface de l'article est effectuée par l'utilisation d'un magnétron (3), et l'évaporation ou pulvérisation de titane sur la surface de l'article est effectuée par l'utilisation d'un évaporateur à arc électrique (1) ou (2), équipé d'un écran (5) monté entre l'évaporateur à arc électrique et l'article, sur lequel le revêtement est appliqué, où l'article, sur lequel le revêtement thermorésistant est déposé, est installé sur un plateau tournant (4) qui, pendant le dépôt des couches intermétallique, conglomérée et/ou de nitrure sur l'article tourne autour de son axis en assurant ainsi un mouvement de l'article dans une chambre à vide de l'équipement.

4. Procédé selon l'une quelconque des revendications précédentes, **caractérisé en ce que** l'alimentation en gaz - gaz inertes et azote - est effectuée de manière régulée séparément ou sous la forme d'un mélange de gaz prêt à l'emploi.

5. Procédé selon l'une quelconque des revendications précédentes, **caractérisé en ce que** le dépôt des couches intermétallique, conglomérée et/ou de nitrure sur l'article est effectué par évaporation ou pulvérisation de titane et d'alliage d'aluminium.

6. Revêtement à triple couche, obtenu selon le procédé, présenté dans les revendications précédentes, où l'épaisseur de la première couche intermétallique de TiAl ou Ti$^3$Al n'est pas supérieure à 2 $\mu$m, la teneur atomique en aluminium est dans la plage comprise entre 40 et 75 % ; l'épaisseur de la deuxième couche conglomérée, contenant TiAl, Ti$_3$Al et nitrures (TiAl)N, intermétalliques dopés à l'azote, n'est pas supérieure à 10 $\mu$m, la teneur atomique en nitrure d'aluminium est dans la plage comprise entre 30 et 70 % ; l'épaisseur de la troisième couche de nitrure (TiAl)N n'est pas supérieure à 1 $\mu$m, la teneur atomique en aluminium dans le composant métallique est dans la plage comprise entre 40 et 70 %.

**Fig. 1**

**Fig. 2**

**Fig. 3**

**Fig. 4**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4814056 A

**Non-patent literature cited in the description**

- **A. URBAHS.** Wear Resistant Nanostructured Multi-component Coatings. NATO Science for Peace and Security Series - B. *Physics and Biophysics,* 2012